# EUROPÄISCHE PATENTANMELDUNG

(11) **EP 0 741 300 A2**
(43) Veröffentlichungstag der Anmeldung: **06.11.1996**
(21) Anmeldenummer: 96106198.3
(22) Anmeldetag: 19.04.1996
(51) Int. Cl.: G01R 31/02

(54) **Verfahren zum Prüfen von beschalteten Stromwegen in Telekommunikationsnetzen**

(30) Priorität: 19.04.1995 DE 19514495
(71) Anmelder: Zimmermann, Wolfgang, 71546 Aspach (DE); Zimmermann, Ria, 71546 Aspach (DE); Rosendahl, Erlend, 74172 Neckarsulm (DE); Wild, Patricia, 71706 Unterriexingen (DE)
(72) Erfinder: Zimmermann, Wolfgang, 71546 Aspach (DE)
(74) Vertreter: Clemens, Gerhard, Dr.-Ing.

(57) **Zusammenfassung**

Ein Verfahren zum Prüfen von beschalteten Stromwegen in Telekommunikationsnetzen mit von Kopplungs- zu Kopplungsstation verlaufenden Kabeln mit (Doppel) -Adern zeichnet sich dadurch aus, daß beim Umschalten von einem alten abzutrennenden oder zu ersetzenden Kabelabschnitt auf einen neuen anzuschließenden Kabelabschnitt zwischen Kopplungsstationen über eine temporäre Ersatzschaltung ein separater Stromkreis erzeugt wird, in dem eine Prüfeinrichtung zum Prüfen der Adern der alten und/oder neuen Kabelabschnitte vorhanden ist, die die Adern mit Prüfspannung/-strom beaufschlagt, und eine Auswerteinheit das Spannungs/-Stromsignal im separaten Stromkreis auswertet. Dieses Verfahren ist einfach und zuverlässig durchführbar und benötigt eine deutlich reduzierte Arbeitszeit gegenüber dem bekannten Verfahren zur Durchführung.

## Beschreibung

### TECHNISCHES GEBIET

Die vorliegende Erfindung betrifft ein Verfahren zum Prüfen von beschalteten Stromwegen in Telekommunikationsnetzen mit von Kopplungs- zu Kopplungsstation verlaufenden Kabeln mit (Doppel)-Adern.

Es ist häufig erforderlich, von einem bestehenden, beschädigten oder gestörten und damit auszutauschenden Fernmeldekabel bzw. den Adern des Fernmeldekabels auf neue störungsfreie Adern eines neuen parallel zu dem bestehenden in einem Kabelkanal eingezogenen oder in offener Bauweise verlegten Fernmeldekabels zwischen zwei Umschaltpunkten umzuschalten. Die Verbindung zwischen den ankommenden und abgehenden Adern an den in den Muffen vorhandenen Adernverbindungen werden häufig mittels einer Adernverbindungsleisteneinrichtung durchgeführt. Diese Adernverbindungsleisteneinrichtungen werden seit Jahren verwendet. Durch Kabelstörungen und Neuplanungen werden täglich die bisherigen Blei- bzw. PWY-Kabel ausgewechselt. Daher treten immer mehr Arbeiten an bestehenden Kabeln auf, die mit Adernverbindungsleisteneinrichtungen miteinander gekoppelt sind. Auch die letzte Kabelgeneration, zum Beispiel PE-Kabel, d.h. Kunststoffisolierung der Kupferadern ist häufig auszuwechseln.

Bei Umschaltarbeiten an beschalteten Stromwegen in Telekommunikationsnetzen wird die Vorprüfung der wegfallenden oder umzuschaltenden Doppeladern zwingend verlangt, da bei einem einseitigen Wegfall von Vertauschungen erneut diese Vertauschungen wirksam werden und zu Störungen führen können, die wiederum Gebührenausfälle und Gebührenreklamationen der Teilnehmer nach sich ziehen. Nachdem vorgeprüft ist und neue Stromwege hinzu oder ersatzgeschaltet worden sind, sind diese Verbindungen vom Anfang bis zum Ende auf Durchgang, Erdschlüsse und die richtige Reihenfolge zu überprüfen.

### STAND DER TECHNIK

Das bekannte Prüfverfahren ist sehr aufwendig und arbeitsintensiv. Hierzu sind in jeder Kopplungsstation Monteure einzusetzen, die die Adern einzeln prüfen und miteinander in Sprechverbindung stehen. Aufgrund der benötigten Arbeitszeit entstehen hohe Kosten.

### DARSTELLUNG DER ERFINDUNG

Der vorliegenden Erfingung liegt, ausgehend von dem genannten Stand der Technik, das technische Problem bzw. die Aufgabe zugrunde, ein verbessertes Verfahren zum Prüfen von beschalteten Stromwegen in Telekommunikationsnetzen anzugeben, das einfach und zuverlässig durchführbar ist und eine deutlich reduzierte Arbeitszeit gegenüber dem bekannten Verfahren zur Durchführung benötigt.

Das erfindungsgemäße Verfahren ist durch die Merkmale des unabhängigen Anspruchs 1 gegeben. Vorteilhafte Ausgestaltung und Weiterbildungen sind Gegenstand der Unteransprüche.

Das erfindungsgemäße Verfahren der eingangs genannten Art zeichnet sich demgemäß dadurch aus, daß beim Umschalten von einem alten abzutrennenden oder zu ersetzenden Kabelabschnitt auf einen neuen anzuschließenden Kabelabschnitt zwischen Kopplungsstationen über eine temporäre Ersatzschaltung ein separater Stromkreis erzeugt wird, in dem eine Prüfeinrichtung zum Prüfen der Adern der alten und/oder neuen Kabelabschnitte vorhanden ist, die die Adern mit Prüfspannung/-strom beaufschlagt, und eine Auswerteinheit das Spannungs/-Stromsignal auswertet. Nach dem erfindungsgemäßen Verfahren werden alle beim Abarbeiten der Kabeladern erkannten Fehler beim Vorprüfen und nachprüfen unmittelbar erkannt und können innerhalb kürzester Zeit behoben werden (3 bis 4 Minuten). Das hat zur Folge, daß keine stundenlangen Fehler im Netz sind, was in der Vergangenheit die unangenehme Folge hatte, daß die Störungssuchperson ausrücken mußte und daß die Teilnehmer unter Umständen eine falsche Rufnummer hatten. Dabei werden zur Bildung des separaten Stromkreises bevorzugt Adern des neuen Kabels eingesetzt oder eine temporäre Verbindung benutzt.

Bei dem erfindungsgemäßen Verfahren wird von der Überlegung ausgegangen, daß beim Umschalten von Adern bereits neu eingezogene noch nicht angeschlossene Adern bzw. Kabel vorhanden sind, die zeitweise als Ersatzadern für den temporären Stromkreis verwendet werden. Durch die Bildung eines Stromkreises kann mittels der lediglich an einer Kopplungsstation benötigten Prüfeinrichtung sowohl der alte zu entfernende Kabelabschnitt mit seinen Adern auf Vertauschung überprüft werden als auch daran anschließend der neu anzuschließende Kabelabschnitt mit seinen Adern.

Die Auswertung erfolgt bevorzugt mittels einer Whitstonschen Brücke (Doppelbrücke), mit der der Schleifenwiderstand des entstandenen separaten Stromkreises in Brückengleichgewicht gebracht wird. Der ermittelte Ohmsche Wert wird als Meßgröße für alle weiteren Prüfungen herangezogen. Die Brücke kann eine Gleich- oder Wechselstrombrücke sein, vorzugsweise mit 200 Hz, da diese Frequenz wenig störend wirkt.

Um Störungen hinsichtlich der während des Prüfvorgangs in die Adern eingebrachte Spannung zu minimieren hat es sich nach einem weiteren Merkmal des erfindungsgemäßen Verfahrens als günstig herausgestellt, die Prüfspannung bei jedem Prüfvorgang von 0 V (Volt) auf einen einstellbaren Endwert, insbesondere 3 V (Volt), mit einer vorgebbaren Steigung hochzufahren.

Üblicherweise sind die Kabel selbst in einzelne Adernstränge unterteilt, wobei die einzelnen Adern in den Kopplungsstationen über sogenannte Adernverbindungsleisteneinrichtungen miteinander kontaktiert werden. Die Adernverbindungsleisteneinrichtung weist von außen zugängliche Öffnungen auf, die ebenfalls eine Kontaktierungsmöglichkeit bieten. Ausgehend von einer derartigen bekannten Adernverbindungsleisteneinrichtung zeichnet sich eine besonders bevorzugte Ausgestaltung des erfindungsgemäßen Verfahrens, die eine sehr hohe Arbeitszeitersparnis mit sich bringt, dadurch aus, daß der Anschluß der temporären Ersatzschaltung zum Prüfen durch auf die Adernverbindungsleisteneinrichtung in die Öffnung aufsteckbare Kontakteinheiten erfolgt. Dabei ist die Kontakteinheit so ausgebildet, daß sie beim Aufsetzen mit sämtlichen (Doppel)-Adern der Adernverbindungsleisteneinrichtungen Kontakt herstellt.

Nach einem weiteren Merkmal zeichnet sich das erfindungs-gemäße Verfahren dadurch aus, daß die Adern der temporären Ersatzschaltung von Kopplungsstation zu Kopplungsstation verlaufen.

Erfindungsgemäß können ebenso mittels Kontakteinheiten, die durch die Ummantelung der Adern hindurch Kontakt herstellen an straff durchlaufenden Kabeln - also nicht nur an vorhandenen Muffen - durch Ankontaktieren und Verlängern über die oben beschriebene temporäre Verbindung unterbrechungsfreie Umschaltungen durchgeführt werden. Hier müssen dann neue Adernverbindungseinrichtungen eingebaut werden. Bei diesen Gegebenheiten kann das erfindungsgemäße Prüfungsverfahren ebenfalls angewendet werden.

Weitere Ausführungsformen und Vorteile der Erfindung ergeben sich durch die in den Ansprüchen ferner aufgeführten Merkmale sowie durch die nachstehend angegebenen Ausführungsbeispiele. Die Merkmale der Ansprüche können in beliebiger Weise miteinander kombiniert werden, insoweit sie sich nicht offensichtlich gegenseitig ausschließen.

### KURZE BESCHREIBUNG DER ZEICHNUNG

Die Erfindung sowie vorteilhafte Ausführungsformen und Weiterbildungen derselben werden im folgenden anhand der in der Zeichnung dargestellten Beispiele näher beschrieben und erläutert. Die der Beschreibung und der Zeichnung zu entnehmenden Merkmale können einzeln für sich oder zu mehreren in beliebiger Kombination erfindungsgemäß angewandt werden. Es zeigen:
- Fig. 1:: schematische Darstellung der Verbindungssituation zwischen Fernmeldeamt und Teilnehmer,
- Fig. 2:: schematische Darstellung einer bekannten Adernverbindungsleisteneinrichtung,
- Fig. 3:: schematische Detailperspektive einer Umschaltvorrichtung und einer Adernverbindungsleisteneinrichtung in teilweise aufgeschnittenem Zustand,
- Fig. 4:: schematische Darstellung einer Prüfungssituation,
- Fig. 5:: schematische Darstellung einer Prüfungssituation mit schematisch dargestellter Prüfeinrichtung
- Fig. 6:: schematische Darstellung des zeitlichen Spannungsverlaufs bei Beginn des Prüfungsverfahrens,
- Fig. 7:: vereinfachte schematische Darstellung einer Prüfeinrichtung mit Schaltrelais,
- Fig. 8:: schematisches Blockschaltbild einer Prüf- und Auswertevorrichtung unter Einsatz von Schaltrelais, und
- Fig. 9 und 10: schematische Darstellung des Umschalt- und Prüfvorgangs bei straff durchlaufendem Kabel.

### WEGE ZUM AUSFÜHREN DER ERFINDUNG

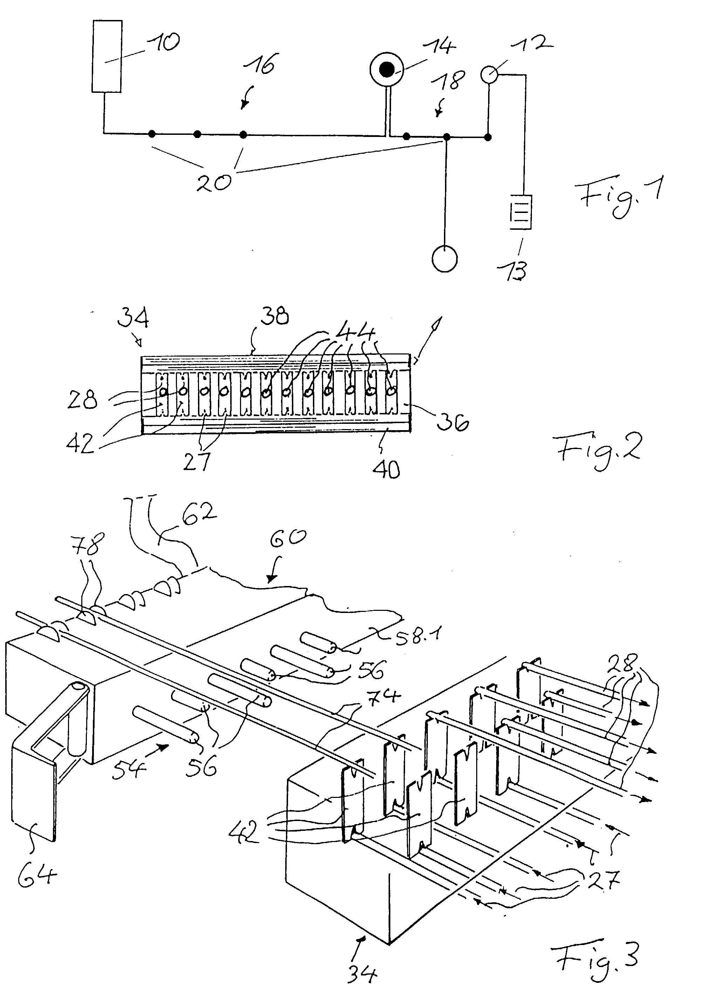

Fig. 1 zeigt schematisch den Verbindungsweg von einem Fernmeldeamt 10 zu einem Hausanschluß (APL) 12 bzw. einer Teilnehmereinheit 13. Zwischen das Fernmeldeamt 10 und die Teilnehmereinheit 13 ist eine Verteilereinheit 14 und ein Kabelendpunkt (APL) 12 geschaltet, wobei links von der Verteilereinheit 14 der Hauptkabelbereich 16 und rechts von der Verteilereinheit 14 der Verzweigerkabelbereich 18 vorhanden ist. Im Hauptkabelbereich 16 sind Kopplungsstationen mit Verbindungsmuffen 20 vorhanden, innerhalb derer die Adern der Fernmeldekabel verbunden werden. Derartige Verbindungsmuffen sind auch im Verzweiger-Kabelbereich 18 vorhanden.

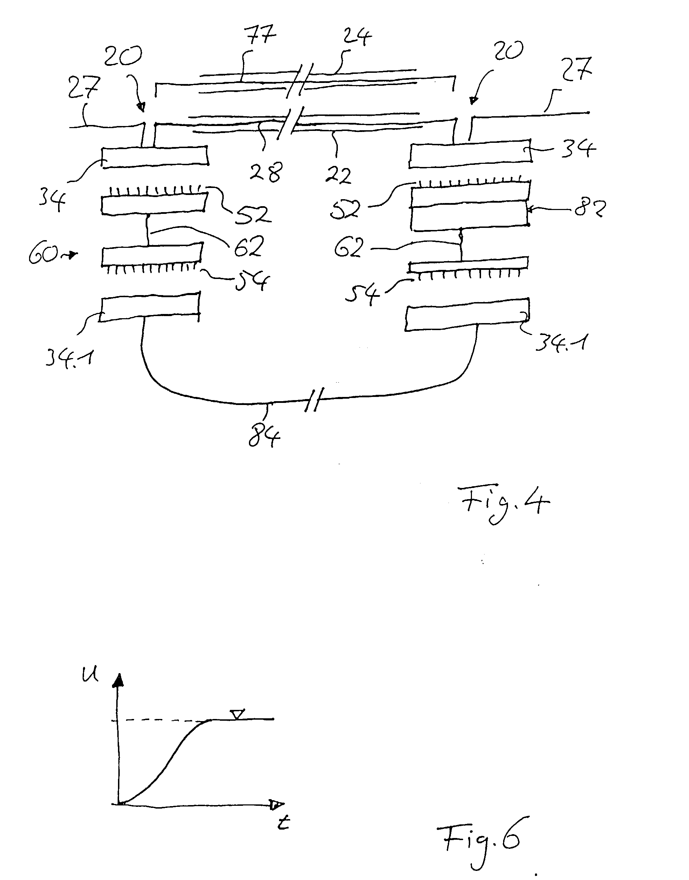

Fig. 4 zeigt schematisch die Situation des Umschaltens von einem auszutauschenden Fernmeldekabel 22 mit Adern 28 auf ein neues Fernmeldekabel 24, das bereits im Bereich zwischen der jeweiligen Verbindungsmuffe 20 in einem Kabelkanal verlegt ist, und dessen Adern 77 an die Adern 28 der an die jeweilige Verbindungsmuffe 20 anschließenden Kabelbereiche angeschossen werden muß. In einer Muffe 20 sind in der Regel eine Vielzahl von bekannten Adernverbindungsleisten-Einrichtungen vorhanden, die jeweils eine vorgegebene Anzahl von leitenden Verbindungen zwischen den ankommenden und abgehenden Adern elektrisch verbinden.

Gemäß Fig. 2 besteht eine bekannte Adernverbindungsleisteneinrichtung 34 aus einer mittig angeordneten Adernverbindungsleiste 36 und einer auf der Oberseite vorhandenen Deckeleinheit 38 und einer auf der Unterseite vorhandenen Bodeneinheit 40. Die Adernverbindungsleiste 36 weist pro anzuschließende Ader eine erste Kontakteinrichtung 42 auf, an der die Adern 28 des ankommenden Fernmeldekabels 32 elektrisch leitend anschließbar sind und gleichzeitig die Adern des auszutauschenden Fernmeldekabels 22 elektrisch leitend angeschlossen sind. Die Adernverbindungsleiste 36 weist für jede Kontakteinheit 42 Öffnungen 44 auf, wodurch die Kontakteinheiten 42 von außen her punktuell zugänglich sind. Die Kontakteinheiten 42 sind in Längsrichtung gesehen zueinander versetzt vorhanden, so daß Prüföffnungen 44.1 und 44.2 mit unterschiedlicher Länge vorhanden sind (siehe Fig. 3).

Eine mögliche schematisch dargestellte Form einer Umschaltvorrichtung 60 ist in Fig. 3 als Detailaufschnitt schematisch dargestellt. Die Umschaltvorrichtung 60 weist eine erste Kontakteinrichtung 52 und eine in leitendem Kontakt mit der ersten Kontakteinrichtung 52 stehende zweite Kontakteinrichtung auf, welche Kontakteinrichtungen jeweils Kontaktelemente 56 aufweisen, welche in dem selben Rastermaß angeordnet sind wie die Öffnungen 44 der Adernverbindungsleiste 36. Beide Kontakteinrichtungen 52, 54 sind über ein angeschlossenes flexibles Kabel 62 miteinander verbunden. Die zweite Kontakteinheit ist in Fig. 4 dargestellt und trägt das Bezugszeichen 54. Die Länge der als Kontaktstifte ausgebildeten Kontaktelemente 56 entspricht im wesentlichen der Länge der jeweils zugeordneten Öffnung 44, wobei diese Kontaktelemente 56 längsverschieblich gelagert sind und federnd gegen die Kontakteinheiten 42 in eingestecktem Zustand gepreßt werden. Schematisch ist in Fig. 3 noch eine an der Seitenwandung vorhandene Klemmeinrichtung 64 dargestellt, wodurch eine Lagesicherung der Umschaltvorrichtung im auf die Adernverbindungsleisteneinrichtung 34 aufgesteckten Zustand gewährleistet werden soll. Diese Klemmeinrichtung 64 kann auch konstruktiv andersartig ausgebildet sein. Wesentlich ist bei der Ausbildung der Klemmeinrichtung, daß diese die Montage der Adern beim Umschaltverfahren nicht behindert und gleichzeitig die Adernverbindungsleisteneinrichtung 34 mit aufgesteckter Umschaltvorrichtung 60 in bekannte Spleißkämme eingelegt werden kann.

Die Anzahl der Kontaktelemente 56 pro Umschaltvorrichtung pro Kontakteinrichtung ist abhängig von der Anzahl der Kontakteinheiten der jeweils umzuschaltenden Adernverbindungsleisteneinrichtung. Bevorzugt werden Umschaltvorrichtungen mit zehn, zwanzig, vierzig oder fünfzig Kontaktelementen eingesetzt.

Um die Lagefixierung der einzelnen Adern beim Anschließen mit aufgesteckter Umschaltvorrichtung 60 zu gewährleisten, weist die Umschaltvorrichtung 60 gemäß Fig. 3 für jede neu anzuschließende Ader 77 ein Klemmbackenpaar 78 auf, in dem die einzelne Ader 77 während des Montagevorgangs lösbar geklemmt werden kann.

Fig. 4 zeigt schematisch die Vorgehensweise bei dem erfindungsgemäßen Prüfungsverfahren. Die Situation ist die, daß das zwischen den Verbindungsmuffen 20 vorhandene Kabel 22 erneuert werden muß. Das neu anzuschließende Kabel 24 ist bereits parallel zum alten Kabel 22 in den Kabelschacht eingezogen bzw. im Erdreich verlegt worden. In den Kabeln 22, 24 befinden sich Doppeladern, von denen aus Übersichtsgründen jeweils nur eine Ader 28 bzw. 77 dargestellt ist. Die Ader 27 ist noch im Bereich der Verbindungsmuffe 20 an die Adernverbindungsleisteneinrichtung 34 angeschlossen. Auf die linke Adernverbindungsleisteneinrichtung 34 wird die Umschalteinrichtung 60 aufgesteckt. Die Anzahl der Kontaktelemente 52 bzw. 54 entspricht der Anzahl der umzuschaltenden bzw. zu prüfenden Adern, wobei wie bereits oben ausgeführt, in Figur 4 lediglich eine Ader dargestellt ist.

Die in Figur 4 unten dargestellte Ader 84 dient als temporäre Prüfader und stellt beispielsweise eine Ader des neu anzuschließenden Kabels 24 dar. Die Anzahl der Adern ist auch hier aus Übersichtsgründen auf 1 reduziert dargestellt.

Im Endbereich der Ader 84 ist wiederum eine Hilfsadernverbindungsleisteneinrichtung 34.1 angeschlossen, die auf die Umschalteinrichtung 60 über die Kontakteinrichtung 54 aufgesteckt wird. In dem in Fig. 4 rechts dargestellten Anschlußbereich liegt dem Grunde nach die gleiche Anschlußsituation vor wie im linken Bereich, jedoch mit dem Unterschied, daß hier eine Prüfeinrichtung 82 eingesetzt wird. Ist die Ader 84 auf beiden Seiten angeschlossen, liegt ein geschlossener Stromkreis vor und die Adern 25 des alten Kabels 22 können mittels der Prüfeinrichtung 82 auf Störung, Vertauschung oder dergleichen geprüft werden.

Mit der eingesetzten Umschaltvorrichtung 60 ist ein unterbrechungsloses Umschalten der Adern 28 des alten Kabels 22 auf die Adern 77 des neuen Kabels 24 möglich, da die im linken Bereich der Verbindungsmuffe 20 ankommenden Adern 27 mit den im rechten Bereich der Verbindungsmuffe 20 abgehenden Adern 27 in leitendem Kontakt stehen. Wird die Umschaltvorrichtung 60 bzw. Prüfeinrichtung 82 eingesetzt, so können die entsprechenden Adern 28 des alten Kabels 22, die mittels der Umschaltvorrichtung 60 überbrückt werden, abgetrennt und durch entsprechende Adern 77 des neuen Kabels 24 ersetzt werden.

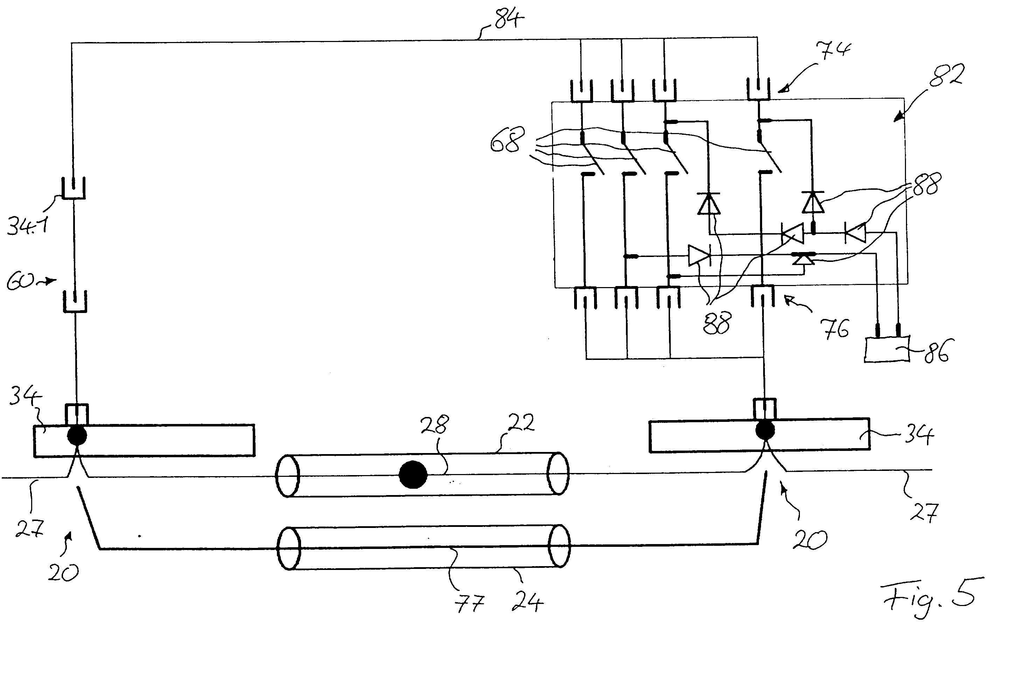

Fig. 5 zeigt schematisch die eingesetzte Prüfeinrichtung 82. Gleiche Bauteile tragen das gleiche Bezugszeichen und werden nicht nochmals erläutert. Aus Gründen der Veranschaulichung sind in Fig. 5 im Anschlußbereich 74 der Prüfeinrichtung 82 für die Adern 84 und im Anschlußbereich 76 jeweils insgesamt 4 Adern dargestellt. Die Prüfeinrichtung 82 ist so ausgebildet, daß die Verbindung der jeweiligen Adern zu Prüfzwecken durch eine Schalteinheit 68 temporär unterbrochen werden kann. Die Prüfeinrichtung weist eine eigene Stromversorgungseinheit 86 auf.

Die Prüfung des durch das erfindungsgemäße Verfahren erzeugten Stromkreises der einzelnen Adern erfolgt über in Fig. 5 schematisch dargestellte Halbleiterdiodenschaltungen 88, die dem Fachmann geläufig sind. Das Ergebnis der Prüfung wird über eine nicht dargestellte Anzeigeeinheit angezeigt.

Im geöffneten Zustand der Schalteinheit 68 wird somit eine elektronische Prüfeinrichtung 82 mit eigener Stromversorgung zwischengeschaltet, die den Prüfvorgang vornehmen kann. So können beispielsweise die Kontaktierung der Umschalteinrichtung 30 mit der Adernverbindungsleisteneinrichtung 34 bzw. 34.1 sowie die Kontakte der Umschalteinrichtung 80 mit den entsprechenden Adernverbindungsleisteneinrichtungen 34 und 34.1 überprüft werden. Gleichzeitig ist die Überprüfung der Adern 28 des wegfallenden Kabels 22 möglich. Sobald das neue Kabel 24 angeschlossen ist, ist die Überprüfung der Adern 77 ebenfalls möglich.

Die einzelnen Bauelemente der Prüfeinrichtung 82 sind so auszuwählen und auszulegen, daß in der für den Fachmann problemlos herstellbaren Prüfschaltung ein Höchstmaß an Entkopplung umgesetzt wird. Dabei muß die gegenseitige Beeinflussung der Adern untereinander vermieden werden. Bei den Prüfungen des alten und des neuen Kabels werden alle Vertauschungen, Berührungen, Unterbrechungen und Fremdspannungen erkannt.

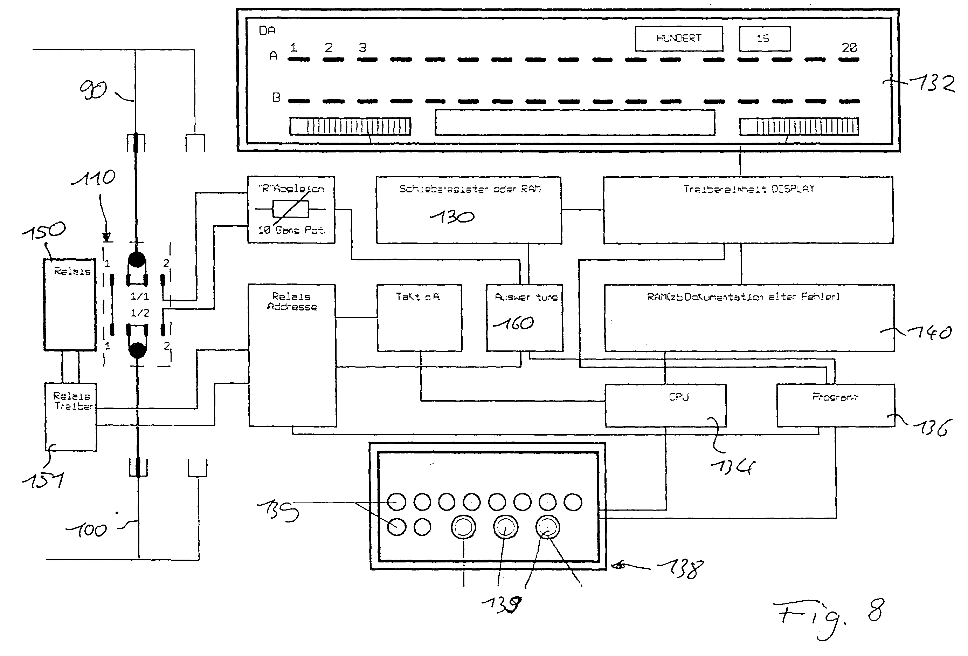

Um alle Wechselwirkungen und elektrische Beeinflussungen der beschalteten Stromwege auszuschließen, werden für jede einzelne Ader vorzugsweise Miniaturrelais eingesetzt, die bipolare Eigenschaften haben. Eine vereinfachte schematische Darstellung einer derartigen Prüfvorrichtung ist in den Figuren 7 und 8 dargestellt. Einen schematischen Überblick zeigt zunächst Fig. 7. Ankommende Adern 90, 91, 92, 93,... werden an ein Relais 150 mit Relaistreiber 151 an einzelne Schalteinheiten 110, 111, 112, 113,... angeschlossen. Genauso sind entsprechend abgehende Adern 100, 101, 102, 103,... geschaltet. Die Stellung der Schalteinheiten 110,... wird mittels einer Abgleich- bzw. Auswertungseinheit 160 ausgewertet.

Gemäß Fig. 8, die ein schematisches Blockschaltbild zeigt, kann die Schalteinheit 110 des Relais 50 die Stellung "1" oder "2" einnehmen. In der Stellung "1" wird geprüft, ob die Ader in Ordnung ist. Das Ergebnis der Prüfung (1 Bit "0" oder "1") wird in einem Schieberegister 130 oder einem anderen Speichermedium festgehalten. Ist das Ergebnis in Ordnung, so wird das Relais 150 bzw. die Schalteinheit 110 in Stellung "2" geschaltet, was dann eine niederohmige Umschaltverbindung darstellt. Danach wird über einen Zähler die nächste Ader 91 bzw. 101 bearbeitet. Dieser Bearbeitungsvorgang erfolgt für jede Ader. In Fig. 7 sind die Adern 110, 111 bereits geprüft und die Ader 112 befindet sich gerade im Prüfzustand. Die "offene" Mittelstellung des Relais 50 kann schaltungstechnisch auch über ein Hilfsrelais umgesetzt werden.

Das Schieberegister 130 wird ausgelesen und der Inhalt einem LCD-Display 132 zugeleitet. Der gesamte Vorgang erfolgt hierbei programmgesteuert über einen Mikroprozessor 134 (CPU) mit entsprechendem Programm 136. Daneben ist noch eine Tastatur 138 vorhanden mit einzelnen Einstellelementen 139 zur Eingabe der jeweiligen Adernnummer. Schließlich ist noch an die CPU 134 eine Rameinheit 140 angeschlossen, in der eine Dokumentation der erkannten alten Fehler gespeichert ist. Hierzu ist eine Zehnertastatur vorhanden, damit die Hauptbündel, die aus 100 oder 50 Doppeladern bestehen, von 1 bis maximal 20 eingegeben werden können, um eindeutige Doppeladern zu identifizieren. In der Regel werden die Doppeladern in der Praxis nicht in der Reihenfolge des Kabels abgearbeitet, sondern nach den Umständen und jeweiligen Platzverhältnissen.

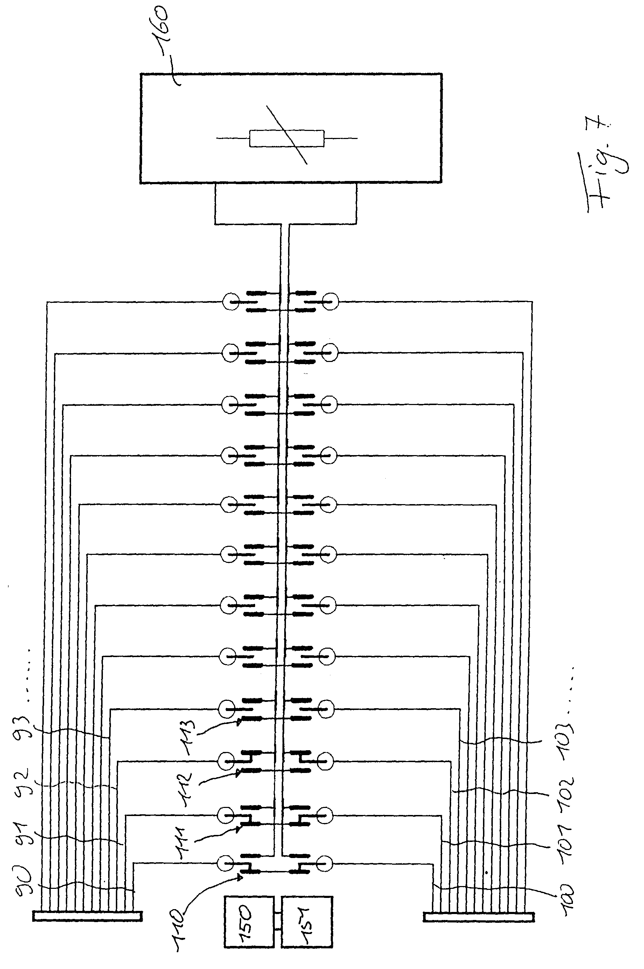

Mehrfachfehler müssen nacheinander ermittelt und beseitigt werden. Ein großer Vorteil des dargestellten Prüfungsverfahrens ist, daß die Umschaltvorrichtung mehrfach auf Funktionssicherheit geprüft wird und zwar zunächst bei "unkritischer" Anwendung, d. h. beim Durchführen des Prüfungsverfahrens selbst, und in "kritischer" Anwendung, d. h. bei dem eigentlichen Umschaltvorgang. Diese Vorgehensweise erbringt ein Höchstmaß an Betriebssicherheit und erspart enorm viel Zeit, da sich die sonst üblichen manuellen Prüfvorgänge erübrigen. Die komplette Umschalt- oder Prüfeinrichtung prüft laufend die eigene Betriebssicherheit. In Fig. 6 ist schematisch der zeitliche Spannungsverlauf beim Prüfen dargestellt. Die Prüfspannung wird nicht sprungartig angelegt sondern behutsam mittels entsprechender elektronischer Bauteile durch definiertes Hochfahren angelegt. Die Prüfspannung bewegt sich insbesondere in einem Bereich bis zu 3 Volt.

Die Prüfvorrichtung kann mit diskreten Komponenten bestückt sein, wobei zur optischen Anzeige Lumineszenzdioden (LED) für die jeweilige Ader eingesetzt werden können.

Die Prüfvorrichtung kann auch digital arbeiten, in dem die Prüfungsergebnisse für die einzelnen Adern mittels einer Scaneinrichtung abgegriffen werden und die Ergebnisse auf einem Display alphanumerisch angezeigt werden.

In einer nicht dargestellten Ausführungsvariante wird durch die Prüfungseinrichtung mittels einer in der Einrichtung befindlichen Konstantstromwelle der Leitungswiderstand erfaßt, wobei sämtliche Adern über einen Komperator verglichen werden und die entsprechenden Ergebnisse angezeigt werden. Die Schaltereiheit kann bevorzugt als mechanischer Schalter in Form eines Schiebeschalters ausgebildet sein, der alle Adern gemeinsam öffnet oder schließt.

Die Prüfvorrichtung kann in einem separaten Gehäuse untergebracht sein, wobei in diesem Fall entsprechende Anschlußmöglichkeiten für die Umschalteinrichtung vorhanden sind.

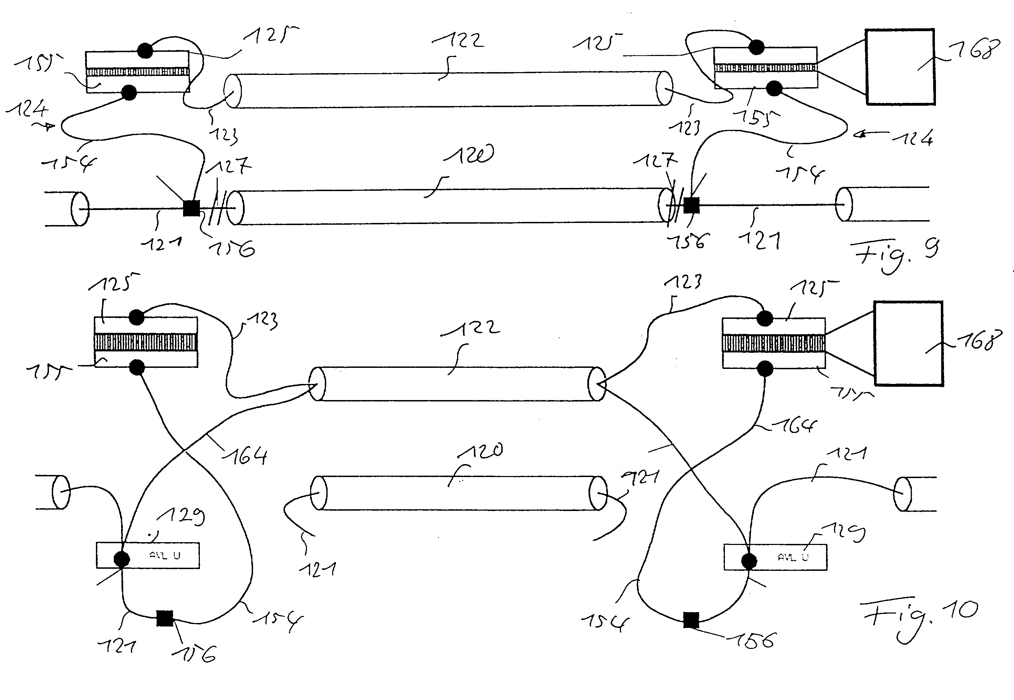

Schwierige und aufwendige Umschaltungen sind an ungeschnittenen und straffen Kabeln an einem Aufgrabepunkt im Gelände gegeben. Auch hier kann die erfindungsgemäße Prüfungseinrichtung zum Vorprüfen, d. h. Prüfen das alten Kabels, und Nachprüfen, d. h. Prüfen des neuen Kabels in einfacher Art und Weise eingesetzt werden. Die schematische Vorgehensweise ist in den Fig. 9 und 10 dargestellt. Ein altes Kabel 120 muß an den entsprechenden Umschaltstellen abgemantelt werden, um die Adern 121 freizulegen. Danach wird ein neues Kabel 122 vorbereitet und die temporäre Verbindung zwischen Adern 123 des neuen Kabels und Adern 121 des alten Kabels 120 mittels Hilfsadernverbindungsleisten (AVL) 125 hergestellt. Auf die Hilfsadernverbindungsleisteneinrichtung (AVL) 125 wird nun eine Verbindungseinheit 124 mit Adern 154 aufgesetzt, die an ihrem einen Ende eine passend zu der AVL 125 ausgebildete Kontakteinheit 155 und an ihrem anderen Ende eine Kontakteinheit 156, die durch die Ummantelung der Adern 121 hindurch Kontakt mitherstellt. Dies geschieht an beiden Seiten, nahe des Abbundes der wegfallenden Seite. In diesem Zustand läßt sich das alte Kabel 120 komplett über die Prüfeinrichtung 168 vorprüfen.

Danach wird an der Stelle 127 die Ader 120 abgetrennt. Die nun so über die Ader 154 verlängerte Ader 121 kann nun in eine Adernverbindungsleisteneinrichtung (AVL U) 129 eingelegt werden, die ein Durchlaufen der unten angeordneten Adern ermöglicht, ohne daß die Ader selbst beim Verpressen der Ader durchschnitten wird. In diese Adernverbindungsleisteneinrichtung 129 (AVL U) wird nun oberseitig eine neu anzuschließende Ader 164 eingelegt und die Verbindung wird verpreßt. Dieser Vorgang wird auf beiden Seiten des Kabels an den Umschaltmuffen durchgeführt.

Um eine Nachprüfung durchführen zu können, müssen beide Muffen mit der Adernverbindungsleiteneinrichtung 129 (AVL U) gespleißt werden, um einen geschlossenen Stromkreis aufrecht zu erhalten. Nach der Prüfung wird an der Stelle der AVU 129 entknotet. In den Fig. 9 und 10 ist zwischen die Hilfs-AVL 125 und der Kontakteinheit 155 der Verbindungseinheit 124 die Prüfeinrichtung 168 im rechten Umschaltpunkt geschaltet.

Wenn im vorigen von Adern die Rede ist, gelten die Ausführungen entsprechend auch für Doppeladern.

## Patentansprüche

1. Verfahren zum Prüfen von beschalteten Stromwegen in Telekommunikationsnetzen mit von Kopplungs- zu Kopplungsstation verlaufenden Kabeln mit (Doppel) -Adern
**dadurch gekennzeichnet,** daß beim Umschalten von einem alten abzutrennenden oder zu ersetzenden Kabelabschnitt auf einen neuen anzuschließenden Kabelabschnitt zwischen Kopplungsstationen über eine temporäre Ersatzschaltung ein separater Stromkreis erzeugt wird, in dem eine Prüfeinrichtung zum Prüfen der Adern der alten und/oder neuen Kabelabschnitte vorhanden ist, die die Adern mit Prüfspannung/-strom beaufschlagt, und eine Auswerteinheit das Spannungs/-Stromsignal im separaten Stromkreis auswertet.

2. Verfahren nach Anspruch 1,
**dadurch gekennzeichnet,** daß zur Bildung des separaten Stromkreises Adern des neu einzusetzenden Kabelabschnitts eingesetzt werden.

3. Verfahren nach Anspruch 1 und/oder 2
**dadurch gekennzeichnet,** daß die Prüfspannung bei jedem Prüfvorgang einer Ader von 0 V (Volt) auf einen einstellbaren Endwert, insbesondere 3 V (Volt) mit einer vorgebbaren Steigung hochgefahren wird.

4. Verfahren nach zumindest einem der vorstehenden Ansprüche, wobei die einzelnen Adern in den Kopplungsstationen über Adernverbindungsleisteneinrichtungen miteinander verbunden sind und die Adernverbindungsleisteneinrichtungen von außen zugängliche Öffnungen aufweisen,
**dadurch gekennzeichnet,** daß der Anschluß der temporären Ersatzschaltung durch auf die Adernverbindungsleisteneinrichtung in die Öffnungen aufsteckbare Kontakteinheiten erfolgt.

5. Verfahren nach zumindest einem der übrigen Ansprüche,
**dadurch gekennzeichnet,** daß die Adern der temporären Ersatzschaltung von Kopplungsstation zu Kopplungsstation verlaufen.

6. Verfahren nach zumindest einem der übrigen Ansprüche,
**dadurch gekennzeichnet,** daß innerhalb der Prüfeinrichtung vom Aderneingang zum Adernausgang die Verbindung durch eine Schalteinheit während des Prüfvorgangs unterbrochen wird.

7. Verfahren nach Anspruch 6,
**dadurch gekennzeichnet,** daß nach Abschluß der Adernprüfung durch die Schalteinheit eine Verbindung vom Aderneingang zum Adernausgang hergestellt wird.
